# EUROPEAN PATENT SPECIFICATION

(11) **EP 0 343 068 B1**
(45) Date of publication and mention of the grant of the patent: **20.07.1994**
(21) Application number: 89401362.2
(22) Date of filing: 17.05.1989
(51) Int. Cl.: G11C 7/00, G11C 11/412

(54) **Sram with flash clear for selectable I/Os**
SRAM mit schneller Löschung von auswählbaren Eingängen/Ausgängen
SRAM avec effacement rapide des entrées/sorties sélectionnables

(30) Priority: 18.05.1988 US 195696
(43) Date of publication of application: 23.11.1989
(60) Divisional application: 93203384.8
(73) Proprietor: SGS-THOMSON MICROELECTRONICS, INC., Carrollton Texas 75006 (US)
(72) Inventor: McClure, David Charles, F-75116 Paris (FR); Lysinger, Mark A., F-75116 Paris (FR)
(74) Representative: Driver, Virginia Rozanne

(56) References cited:
- EP-A- 0 149 043
- EP-A- 0 189 700
- EP-A-02 579 38
- EP-A-02 599 67
- US-A- 4 099 069
- US-A- 4 567 578

## Description

The present invention pertains in general to memories, and more particularly, to a multiple I/O SRAM having the capability of clearing selected memory cells.

The cache memory market is growing at a rapid pace with the advent of the high-performance 32-bit microprocessors. The cache memory is a small but fast memory block typically inserted between the CPU and the primary memory. The CPU fetches data and instructions from the cache when it is determined that the desired data and instructions reside in the cache. Since the cache memory is about ten times faster than the primary memory, the CPU-memory speed gap is considerably reduced when accessing the cache.

In the cache memory scheme, the primary memory and the cache memory are usually divided into equal-size pages. Required pages from the primary memory are first transferred into the cache and execution of the program begins with the CPU fetching data and instructions from the cache. If the address of the instruction to be executed or the data to be fetched is not in the cache memory (i.e., a miss), an appropriate page from the primary memory is transferred into the cache memory. If the address is in the cache memory (i.e., a hit), the execution of instructions from the cache continues. One method for writing data into a primary memory location using a cache scheme requires a tag to be associated with each cache page. The tag indicates whether a page is altered or not due to a memory Write operation. If not altered, the page is discarded and another required page is brought into the cache. Some type of virtual memory management scheme is required to manage the cache-primary memory instructions.

Since the cache memory compares each address generated by the microprocessor with the tag to determine if there is a hit, it is important that the integrity of this tag be maintained such that an invalid hit does not occur. An invalid hit can occur, for example, upon power up of the system since a random sequence of bits is initially stored in the tag. To determine the validity of the tags, one bit in each of the tags is designated as a valid bit. The I/O associated with this valid bit is typically tied to a positive voltage representing the logic high voltage which, when written to the valid bit, provides an indication of a valid tag. Initially, the entire memory is flash cleared such that all zeroes are stored in each of the tag bits until a tag is stored in the address cache, at which time the logic "1" is written in the valid bit for the tag written to. By determining whether the valid bit for the addressed tag is a logic "1", the presence of a hit can be determined.

In prior systems, the memory utilized for both the address cache and the data cache in the cache system utilized static random access memories (SRAM's). The entire memory was cleared upon power up of the system by storing a zero in each of the memory locations by various methods. One method required sequentially addressing all of the memory locations and forcing a zero therein. Another system forces all of the memory locations to zero. One disadvantage to this latter system is that drivers must be present which can drive all of the memory locations to a "0" logic state. In addition, some type of interconnection is required for each of the memory cells which increases the amount of space occupied by the memory array. Typically, each column of memory cells will require a separate run of conductive material to interface with each of the memory cells for the clear function. The drive requirements for clearing all of the memory cells results in relatively large drive transistors. In any event, it is not necessary to clear the entire memory since only one bit determines whether there is valid tag information in a cache memory. There therefor eexists a need for a more versatile memory that allows clearing of less than all of the memory cells.

EP-0259967 describes a semiconductor memory device having a main memory and a cache memory. A validity unit of the device is provided for storing validity bits for indicating a valid/invalid state of address data in each address of the memory unit, and an initialize circuit is arranged to simultaneously invalidate the valid bits.

EP-0257938 describes a digital memory having a column activation means for applying either a reset signal or a preset signal to the columns of a memory matrix to individually reset or preset a particular column.

EP-0189700 describes a static RAM having a flash clear function. The RAM has a flip-flop cell and employs a circuit for simultaneously clearing all cells to a logic zero. A flash clear signal is applied to a flash clear line, which can be shared by adjacent cells bordering the line.

None of these documents provide a memory layout in which particular bits of a data word can be selectively cleared.

According to one aspect of the present invention there is provided a memory with selectively clearable memory cells comprising:
an array of memory cells arranged in rows and columns including memory cells operable to store a first or a second logic state therein and having a flash clear input for forcing the logic state stored therein to said first logic state in response to receiving a flash clear signal, the flash clear inputs for said memory cells in a given one of said columns being commonly connected together;
row address decode means for receiving and decoding a row address and accessing an associated one of said rows of memory cells in said array;
input/output means for interfacing with the accessed ones of said memory cells for inputting data thereto for a write operation and outputting data therefrom for a read operation, wherein memory cells in pairs of adjacent columns have their commonly connected flash clear inputs connected to flash clear means including a first common conductive run disposed adjacent the columns in each pair, said first common conductive run being arranged to receive a flash clear signal for connection to the commonly connected flash clear inputs of the associated ones of said memory cells for clearing thereof in response to said clear signal,
characterised in that said columns of memory cells are configured such that a given column address is associated with a group of said columns of memory cells, there being column address decode means operable to select the group of said columns of memory cells associated with a received column address, each of said columns of memory cells in each group being associated with a separate data bit in a bit sequence, each pair of adjacent columns including columns associated with the same data bit of separate column addresses wherein said flash clear means is operable to connect the flash clear signal to the commonly connected flash clear inputs of memory cells in selected pairs such that memory cells in columns of the selected pairs containing the same data bit of different bit sequences are forced to said first logic state.

According to another aspect of the present invention there is provided a method for selectively clearing memory cells in a multiple input/output memory, comprising:
disposing memory cells in an array in rows and columns;
connecting memory cells in pairs of adjacent columns to a first common conductive run disposed adjacent the columns in each pair;
connecting a flash clear signal to first common conductive run of pairs of adjacent columns to be flash cleared,
characterised in that said columns of memory cells are configured such that a given column address is associated with a group of said columns of memory cells, each of said columns of memory cells in each group associated with a separate data bit in a bit sequence and wherein each pair of adjacent columns includes columns associated with the same data bit of separate column addresses, wherein said flash clear signal is connected to the memory cells in selected pairs such that memory cells in columns of the selected pairs containing the same data bit of different bit sequences are forced to a first logic state.

Thus, the present invention as described herein comprises a multiple I/O memory with selectably clearable cells. The memory includes an array of memory cells arranged in rows and columns with each of the rows accessible with a separate row address and each of the columns arranged in predetermined I/O groups and each column associated with a predetermined I/O. The memory cells are operable to force the logic state stored therein to a first logic state in the presence of a clear signal . An externally generated clear signal is selectively input to columns of memory cells associated with a selected I/O. Therefore, only the columns of memory cells associated with a selected I/O are forced to the first logic state in the presence of the clear signal.

Some of the memory cells embodied in a monolithic integrated circuit are grouped together in pairs such that each pair consists of two columns of memory cells each associated with the same I/O and each associated with an adjacent column address. Each of the memory cells has a clear input which is connected to a common first conductive run which is disposed adjacent and parallel to each of the columns of memory cells in the pair. In the described embodiment, the first conductive runs for the columns of memory cells associated with the selected I/O are connected to a second conductive run disposed adjacent to the array proximate to each of the columns of memory cells. The second conductive run is interfaced with the externally generated clear signal. A driver is provided for driving the distributed capacitance of the first and second conductive runs. Memory cells associated with columns that are not associated with the selected I/O are connected to a source reference voltage instead of to the clear signal; accordingly, the FLASH CLEAR function is not provided for those memory cells.

In the preferred embodiment of the present invention, each of the memory cells is comprised of a static memory cell. The memory cell includes two cross-coupled MOS N-channel transistors having the drains thereof connected to first and second sense nodes, respectively. The source of one of the cross-coupled transistors is connected to a source reference voltage and the source of the second cross-coupled transistor is connected to the clear input. The first and second sense nodes are respectively connected to the drain supply through a pull up device. When the voltage on the clear input is raised to the drain supply voltage, the logic state of the memory cell is forced to a logic "0"; and when the voltage on the clear input is clamped to the source reference voltage, the memory cell operates in a standard manner.

For a more complete understanding of the present invention and the advantages thereof, reference is now made to the following description taken in conjunction with the accompanying Drawings in which:
Figure 1 illustrates a block diagram of an SRAM utilizing the FLASH CLEAR feature of the present invention;
Figure 2 illustrates the architecture of the cell array and the interface with the FLASH CLEAR driver circuitry;
Figure 3 illustrates a schematic diagram of four adjacent columns in the memory array;
Figure 4 illustrates a detailed schematic diagram of one memory cell; and
Figure 5 illustrates a schematic block diagram of a cache memory scheme utilizing the system of the present invention.

### DETAILED DESCRIPTION OF THE INVENTION

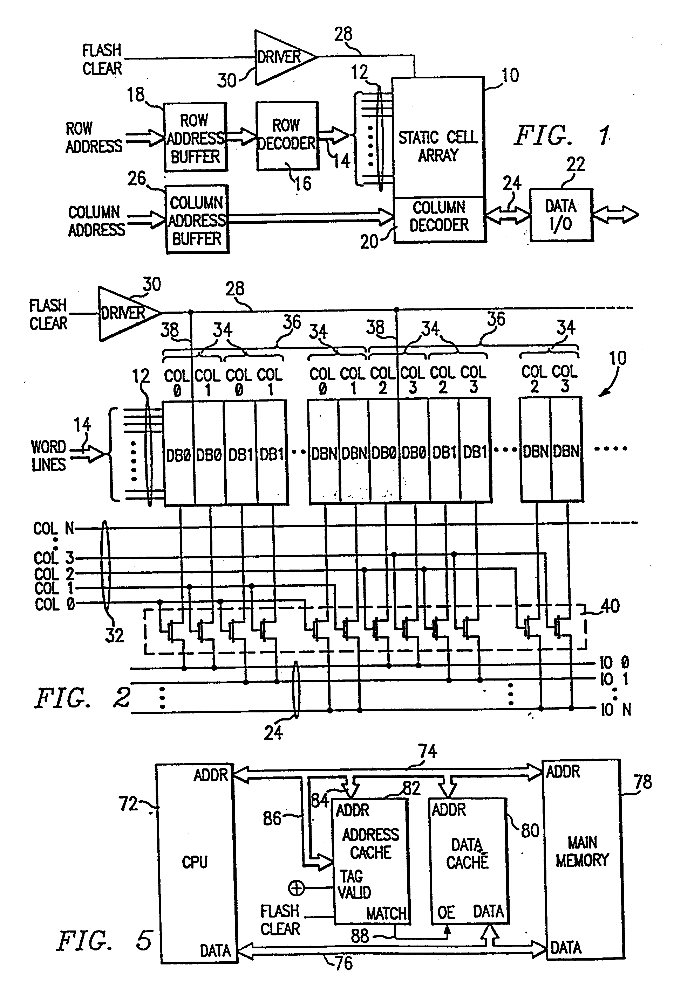

Referring now to Figure 1, there is illustrated a block diagram of an SRAM which may be conveniently fabricated in a monolithic integrated circuit and which utilizes the FLASH CLEAR scheme of the present invention. The memory is comprised of a static cell array 10 which is comprised of a plurality of static memory cells (not shown) arranged in rows and columns. A row of memory cells is selected by activating one of a plurality of Word Lines 12, which are connected to a Word Line bus 14. The Word Line bus 14 is connected to the output of a row decode circuit 16 that is operable to decode a row address which is buffered by a row address buffer 18. The row decode circuit 16 has a mutually exclusive output and selects one of the Word Lines 12 for activation thereof. The memory cells in the row associated with the activated Word Line are then accessed and the contents thereof output on bit lines.

Each of the bit lines in the cell array 10 are connected to a column decode circuit 20 which has the output thereof connected to a data Input/Output (I/O) circuit 22 through a bus 24 which is comprised of a plurality of I/O data lines. The column decode circuit 20 receives a column address from a column address buffer 26. In the preferred embodiment, the column decode circuit 20 is operable to select multiple columns of memory cells for each column address received. Data written to or read from the accessed columns represent an N-bit word. Therefore, the cell array 10 is a "by-N" array.

The cell array 10 has a FLASH CLEAR input associated with a control line 28 which is connected to the output of a driver circuit 30. The driver circuit 30 has the input thereof connected to a FLASH CLEAR control signal. The cell array 10 is operable to preset all memory cells of selected columns of the memory cell array to logic 0's when the FLASH CLEAR signal is input to the driver 30, the selected columns being associated with a common I/O line. By comparison to an arrangement wherein all columns of a memory cell array are necessarily simultaneously flash cleared, the ability to selectively clear any I/O line in the cell array 10 results in lower drive requirements for the driver 30 and a lower associated noise level due to the lower drive current, as will be described in more detail hereinbelow.

Referring now to Figure 2, there is illustrated a partial block diagram of cell array 10 utilizing the flash clearing scheme of the present invention. Typically, columns of memory cells in an integrated circuit are arranged to accommodate various layout considerations, column decoder schemes, etc., such that the columns are not necessarily topologically located in a sequential order relative to their associated I/O line; that is, columns associated with a given column address are not necessarily physically adjacent to each other.

In the preferred embodiment, columns that are associated with a particular one of the data bits DB0̸-DBN are physically grouped together, each of the data bits DB0̸-DBN being associated with a separate I/O line. As will be described hereinbelow, this allows selective clearing of all memory cells associated with a selected data bit. In the preferred embodiment all of the bit DB0̸ are designated as the selected memory cells to be flash cleared. For reasons that will be described hereinbelow, columns associated with the memory cells to be flash cleared for the selected data bit, are physically disposed adjacent to each other in pairs. Each pair represents two adjacent column addresses, for example, Column 0̸ and Column 1. This allows one control line to feed a pair of adjacent columns associated with the memory cells to be cleared.

For example, in the preferred embodiment, the column address COL 0̸ will access memory cells for data bits DB0̸-DBN associated with Column 0̸. In a similar manner, the column address COL 1 will access memory cells for data bits DB0̸-DBN associated with Column 1. The column of memory cells for the DB0̸ data bits associated with the column address COL 0̸ ,and the column of memory cells for the DB0̸ data bits associated with the column address COL 1 are physically disposed adjacent each other with a single control line operative to clear the associated memory cells in response to the FLASH CLEAR signal.

Referring further to Figure 2, the column decoder 20 outputs a plurality of column address lines 32 labelled COL 0̸-COL N. Each of the column address lines 32 is associated with one of N+1 columns and each column address is associated with memory cells for data bits DB0̸-DBN. Therefore, when a row of memory cells is accessed, the presence of the respective column address results in the data bits DB0̸-DBN for the accessed row being output on the data bus 24.

The columns of memory cells are arranged in pairs 34 with each pair 34 representing two adjacent column addresses for a given one of data bits DB0̸-DBN. The pairs 34 are organized in banks 36 with each bank representing all of the columns of memory cells for two adjacent column addresses. For example, in the first bank 36 in the memory array 10, the first pair 34 corresponds to the bits DB0̸ for adjacent column addresses COL 0̸ and COL 1. The next adjacent pair 34 corresponds to the data bits DB1 for adjacent column addresses COL 0̸ and COL 1, with the last pair 34 in the first of the banks 36 corresponding to the data bits DBN for adjacent column addresses COL 0̸ and COL 1. The next adjacent bank 36 corresponds to all of the data bits DB0̸-DBN for adjacent column addresses COL 2 and COL 3, with the last bank 36 representing all of the data bits DB0̸-DBN for adjacent column addresses COL (N-1) and COL N.

Each of the pairs 34 associated with the memory cells for data bits DB0̸ in each of the banks 36 has a control line 38 connected to the FLASH CLEAR control line 28. The line 38 provides an interconnection to the FLASH CLEAR signal through driver 30, which clears all of the memory cells for bits DB0̸ for each bank and for each column address. However, it should be understood that any of the pairs 34 can be connected to the line 28 for the purposes of flash clearing the memory cells associated with that particular data bit. This allows the selection of all of the columns associated with a selected one of data bits DB0̸-DBN to be cleared. Further, for an alternative embodiment, this also allows for selection of a particular column address and memory cells for associated data bits DB0̸-DBN to be cleared. For example, the first bank 36 associated with the column addresses COL 0̸ and COL 1 could be selected such that only the memory cells for the first data bit DB0̸ associated with these two column addresses would be cleared. Although not described herein, this is merely a mask change which requires a jumper to be made from the control line 28, which runs adjacent to the array, to the appropriate terminal in pair 34.

Each of the I/O lines in bus 24 is interconnected to the output of an associated column through one of a plurality of transfer gates 40. Each of the transfer gates comprises an N-channel transistor having a source-to-drain path connected between the respective I/O line and the column output; the gate terminal of each transfer gate is connected to the associated one of the column address lines 32.

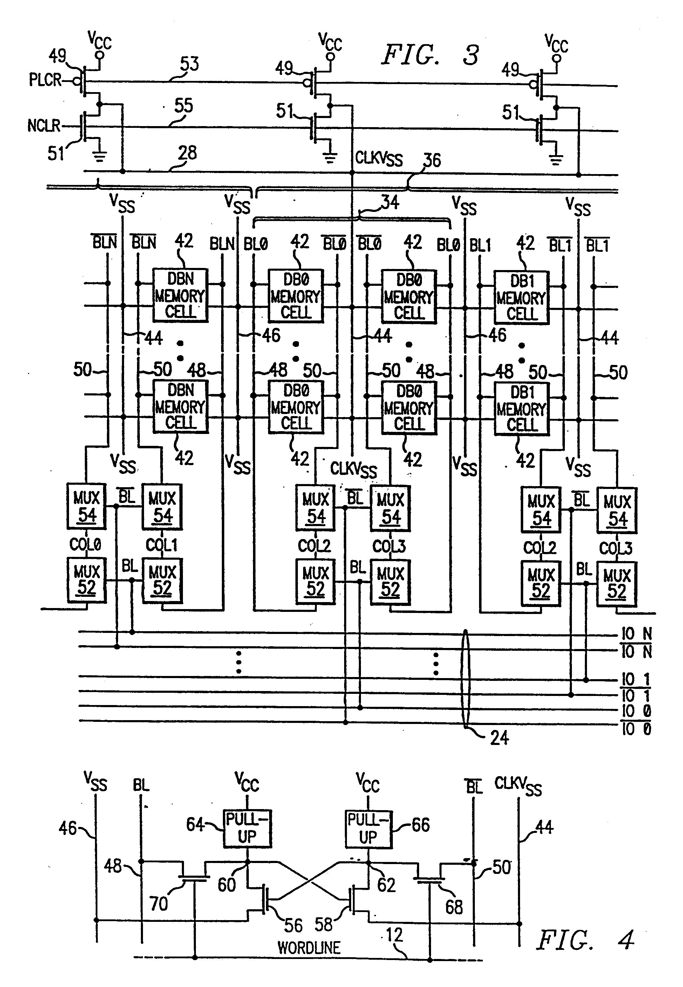

Referring now to Figure 3, there is illustrated a detailed schematic diagram of a portion of the cell array 10 illustrating the interconnections of memory cells 42. The memory cells 42 are arranged in rows and columns such that each memory cell 42 has a specific column and row address location. The wordlines associated with row addresses are not shown. For clarity purposes, the pair 34 in the set associated with the I/O 0̸ line and in the bank 36 associated with the column addresses COL 2 and COL 3 are illustrated. In addition, the column of memory cells 42 associated with both the column address COL 1 and the I/O N line, and the column of memory cells 42 associated with both the column address COL 2 and the I/O 1 line are illustrated.

Each of the memory cells 42 has associated therewith a Bit Line output and a Bit Line-bar output. It should be noted that in any given pair 34, the Bit Line-bar outputs of the associated memory cells 42 are physically located adjacent to one another, whereas the Bit Line outputs are disposed on the opposite sides of the memory cells 42, for reasons that will be described hereinbelow. Each of the memory cells 42 is coupled to two V_{SS} input lines, a V_{SS} input line 44 on the Bit Line-bar side of the memory cell 42 and a V_{SS} input line 46 on the Bit Line side of the memory cell 42.

The V_{SS} input lines 44 for the memory cells 42 in the pair 34 that are associated with the I/O 0̸ line are connected to line 28, which has a signal CLKVSS applied thereto. The remaining memory cells 42 associated with the I/O 1-I/O N lines have the ground reference voltage applied to the V_{SS} input line 44. Each of the V_{SS} input line 46 of all of the memory cells 42 are connected to the ground reference voltage. The CLKVSS signal is utilized to clear the memory cells to which it is coupled. Although the present embodiment only connects the V_{SS} input line 44 of the memory cells 42 associated with the I/O 0̸ line to the control line 28 and the signal CLKVSS, it should be understood that any of the pairs 34 of columns of memory cells 42 could alternately have the V_{SS} inputs 44 thereof selectively connected to the CLKVSS signal to allow FLASH CLEARing of the memory cells in those columns.

Each of the Bit Line outputs of the memory cells 42 is connected to one of a plurality of Bit Lines 48 and each of the Bit Line-bar outputs is connected to one of a plurality of Bit Line-bar lines 50. The Bit Line 48 for each of the columns of memory cells is connected to an associated multiplexer 52 and each of the Bit Line-bar lines 50 is connected to an associated multiplexer 54. The multiplexers 52 and 54 each comprise pass gates similar to the pass gates 40 in Figure 2. Each of the I/O lines in bus 24 has an inverted and a non-inverted form. The inverted form thereof is connected to the output of multiplexer 54 and the non-inverted form is connected to the output of multiplexer 52.

It can be seen from the architecture illustrated in Figure 3 that only one conductive line is required for the CLKVSS signal for a given pair 34 of columns of memory cells. This conductive line is associated with two columns having different column addresses and both columns being associated with the same I/O line, thereby allowing selective flash clearing of all cells associated with a given I/O line without requiring a separate conductive line for the CLKVSS signal to each column of memory cells. By alternating the orientation of the memory cells for a given row such that the Bit Line-bar output of adjacent columns of memory cells 42 are adjacent to each other, it is possible to provide one V_{SS} input line 44 for receiving the CLKVSS signal. All that is required is a memory cell layout having the Bit Line and Bit Line-bar outputs on opposite sides of the cell.

The control line 28 is a conductive run having a distributed capacitance associated therewith and is driven by the driver 30 which comprises a distributed driver. A plurality of CMOS driver circuits are provided, the driver circuits each being represented by a P-channel transistor 49 and an N-channel transistor 51 connected in a complementary configuration between the positive supply V_{CC} and a reference V_{SS} or ground. The drain of the N-channel transistor 51 is connected to the line 28. The CMOS transistor drivers are comprised of transistors 49 and 51 and are distributed along the line 28. In such a manner, a low source impedance can be provided to the line 28. The gates of the P-channel transistors 49 are connected to a control line 53 and the gates of the N-channel transistors 51 are connected to a control line 55 representing the inverted and non-inverted form of the FLASH CLEAR signal and are designated as PLCR and NCLR, respectively. Therefore, the transistors 49 and 51 provide the drive necessary to supply the CLKVSS-signal whereby the voltage of the line 44 connected to the CLKVSS signal can readily be pulled from V_{SS} to V_{CC}. It can be seen that a significantly decreased amount of drive is required to drive only the V_{SS} input lines 44 associated with the I/O 0̸ lines as compared to the amount of drive which would be required to drive all of the cells in the memory array 10.

Referring now to Figure 4, there is illustrated a schematic diagram of one of the static memory cells 42. The memory cell 42 comprises a pair of cross-coupled N-channel transistors 56 and 58. Transistor 56 has the source thereof connected to the V_{SS} input line 46, the drain thereof connected to a sense node 60 and the gate thereof connected to a sense node 62. Transistor 58 has the source thereof connected to the V_{SS} input line 44, the drain thereof connected to the sense node 62 and the gate thereof connected to sense node 60. In the cell 42 illustrated in Figure 4, the V_{SS} input line 44 is connected to the CLKVSS line, and the V_{SS} input line 46, as described above, is connected to V_{SS}, representing a cell that can be flash cleared. However, if the memory cell 42 is not to be flash cleared, the associated V_{SS} input line 44 is connected to V_{SS} rather than to CLKVSS. The source of transistor 58 therefore comprises the FLASH CLEAR input of the memory cell 42.

The sense node 60 is connected to a positive supply V_{CC} through a pull-up transistor 64 and the sense node 62 is connected to the positive supply V_{CC} through a pull-up transistor 66. Node 62 is connected to the Bit-Line-bar 50 through the source-to-drain path of an N-channel access transistor 68, the gate of which is connected to the Word Line 12 for the accessed row. In a similar manner, node 60 is connected to the Bit Line 48 through the source-to-drain path of an N-channel transistor 70, the gate of transistor 70 being connected to Word Line 12. The operation of the memory cell 42 with the V_{SS} input line 44 connected to V_{SS} is identical to a conventional SRAM cell. It should be noted that for the illustrated cell the clear input is on the right side of the cell whereas in the mirrored layout, the cell is mirrored about the center with the clear input on the left side of the cell.

In operation, the memory cell 42 is flash cleared by raising the line 44 from the voltage V_{SS} to the voltage V_{CC}, which operation occurs when the voltages on both line 53 and line 55 go low, thus turning on transistors 49 and turning off transistors 51. When the memory cell 42 is cleared, the non-inverted node 60 is disposed at a low voltage representing a logic "0" and the inverted node 62 is disposed at a high voltage representing a logic "1".

When a logic "1" is stored in the memory cell 42, node 62 is disposed at a low voltage at or near V_{SS}; in this condition transistor 58 is turned on and transistor 56 is turned off. To clear this logic state and force node 62 to a high voltage, the voltage on the source of transistor 58 is pulled to a high voltage such that transistor 58 acts as a source follower and pulls the voltage on node 62 high. This in effect turns on transistor 56, pulling node 60 low, which results in transistor 58 being turned off, such that when the voltage on line 44 is pulled back low, transistor 58 is off and node 62 is high. This provides a clearing operation that does not require any interaction by the row decoder to write logic "0" information from the Bit Lines into the memory cell for the clear operation and, additionally, only minimal power is required.

From a power standpoint, sufficient current is required to overcome the capacitive loading on the drain of transistor 58 from each of the memory cells associated therewith. If all the memory cells 42 in the array 10 were cleared, this would require a high driving current to overcome the capacitive loading, but by clearing only selected I/Os, the capacitive loading and required drive current can be substantially decreased. Further, supplying the CLKVSS signal to all of the memory cells 42 in the array 10 would result in a higher noise level distributed across the memory array 10, and thereby increasing the possibility of an error.

Referring now to Figure 5, there is illustrated a schematic block diagram of a cache memory system illustrating the FLASH CLEAR scheme of the present invention. In the cache memory scheme, a central processing unit (CPU) 72 provides an address output connected to an address bus 74 and a data I/O connected to a data bus 76. The address bus 74 is connected to the address input of a main memory 78, the data input thereof being connected to the data bus 76. The address bus 74 is also input to a data cache 80 with the data input of the data cache 80 connected to the data bus 76. An address cache 82 is also provided which has an address input and a data input, the data input representing the tag information. The address input of the address cache 82 is connected to the three least significant bits of the address through the bus 84. The tag input is connected to the three most significant bits of the address bus 74 through a bus 86. In addition, the address cache 82 has one of the data bits thereof connected to a positive voltage through a pull-up resistor (not shown). The FLASH CLEAR signal is also input to the address cache 82.

The address cache 82 is operable to receive the three least significant bits of the address output by the CPU and to output the addressed location and compare it with the information on the bus 86. If a true comparison is made, a match signal is generated and output on a line 88 to the Output Enable input of the data cache 80. The tag information is stored during a Write operation, which will not be described. When a match is present, this is termed a "hit", which results in the data stored in the data cache 80 being output on the data bus 76. The access time to the data cache as compared to the access time to the main memory 78 is approximately ten times faster, resulting in increased speed.

The FLASH CLEAR input allows the valid bit in the address cache 82 to be cleared without requiring the rest of the memory locations in the address cache 82 to be cleared. As described above, the clearing of selected I/Os removes the requirement for clearing all of the memory locations, thus resulting in lower drive requirements, improved noise levels during clear, etc.

In summary, there has been provided a static random access memory having multiple I/Os with the capability of clearing a selected I/O. The memory is configured such that all columns of memory cells associated with the given I/O can be selectively connected to a clear signal. Further, columns of memory cells for a selected I/O and for two adjacent column addresses are physically disposed adjacent to each other such that they can share a common conductive run disposed parallel to each of the columns and connected to the clear signal. In such a manner, pairs of memory cells associated with the same I/O can be cleared, thus reducing layout constraints.

Although the preferred embodiment has been described in detail, it should be understood that various changes, substitutions and alterations can be made therein without departing from the scope of the invention as defined by the appended claims.

## Claims

1. A memory with selectively clearable memory cells comprising:
an array (10) of memory cells (42) arranged in rows and columns (COL) including memory cells (42) operable to store a first or a second logic state therein and having a flash clear input (28) for forcing the logic state stored therein to said first logic state in response to receiving a flash clear signal, the flash clear inputs for said memory cells in a given one of said columns being commonly connected together;
row address decode means (16,18) for receiving and decoding a row address and accessing an associated one of said rows of memory cells in said array;
input/output means (22) for interfacing with the accessed ones of said memory cells for inputting data thereto for a write operation and outputting data therefrom for a read operation, wherein memory cells in pairs (34) of adjacent columns (COL0;COL1;COL2,COL3) have their commonly connected flash clear inputs connected to flash clear means including a first common conductive run (38) disposed adjacent the columns in each pair, said first common conductive run being arranged to receive a flash clear signal for connection to the commonly connected flash clear inputs of the associated ones of said memory cells for clearing thereof in response to said clear signal,
characterised in that said columns of memory cells are configured such that a given column address is associated with a group of said columns of memory cells, there being column address decode means operable to select the group of said columns of memory cells associated with a received column address, each of said columns of memory cells in each group (COL0 ... COLN) being associated with a separate data bit (DB0 ... DBN) in a bit sequence, each pair (34) of adjacent columns including columns associated with the same data bit (DB0) of separate column addresses (COL0,COL1;COL2,COL3) wherein said flash clear means (28,30,38) is operable to connect the flash clear signal to the commonly connected flash clear inputs of memory cells in selected pairs such that memory cells in columns of the selected pairs containing the same data bit (DB0) of different bit sequences are forced to said first logic state.

2. The memory of claim 1, wherein said memory cells comprise static memory cells (42).

3. The memory of claim 1 or 2, wherein said flash clear means further comprises:
a second conductive run (28) disposed adjacent to said array (10) and proximate to each of said columns of memory cells, said second conductive run connected to the ones of said first conductive runs (38) associated with the selected pairs of said columns of cells; and
driver means (30) for receiving said flash clear signal and driving said second conductive run (28) and the ones of said first conductive runs (38) connected thereto with said clear signal to supply said flash clear signal to all of said memory cells having the flash clear inputs thereof connected through the associated ones of said first conductive runs to said second conductive run.

4. The memory of claim 3, wherein the driver means comprises:
a plurality of driver circuits (49,51) distributed along the second conductive run, wherein the driver circuits simultaneously drive a flash clear signal onto the second conductive run.

5. The memory array of claim 4, wherein the driver circuits are spaced at regular intervals along the second conductive run across one dimension of the array, and are aligned with all of the columns in the array, including those not connected to common conductive runs.

6. The memory of claim 3, 4 or 5, which comprises interconnection means for selectively interconnecting the ones of said first conductive runs (38) associated with said selected pairs with said second conductive run (28).

7. The memory of claim 6, wherein said second conductive run is disposed adjacent to said array and perpendicular to said first conductive runs, and said interconnection means comprises a conductive interconnect between the ones of said first conductive runs associated with the selected pairs of said columns and said second conductive run.

8. The memory of any preceding claim wherein:
said flash clear signal (CLKVss) has a first state at a first voltage level (Vcc) and a second state at a second voltage level (Vss) and each of said memory cells (42) is operable to force the logic state stored therein to said first logic state when said first voltage level is applied to the flash clear input thereof, and said memory cells not having the logic state thereof altered when said second voltage level is applied to the flash clear input thereof; and
said flash clear means (49,51) is operable to apply said first voltage level (Vcc) to the flash clear inputs of said memory cells in the selected pairs (34) of said columns and said second voltage level (Vss) to the flash clear inputs of said memory cells in the unselected pairs of said columns when said flash clear signal is present.

9. The memory of claim 8, wherein said means for applying said first voltage level to said second conductive run comprises a driver (49) having the input thereof interfaced with said flash clear input and the output thereof operable to drive said second conductive run.

10. The memory of any preceding claim, wherein said first and second conductive runs have a distributed capacitance associated therewith.

11. The memory of any preceding claim, wherein each of said memory cells comprises:
a first sense node (60);
a second sense node (62);
a first transistor (56) having a source-to-drain path connected between said first sense node (60) and a node providing a second voltage level (Vss) and the gate thereof connected to said second sense node (62);
a second transistor (58) having a source-to-drain path thereof connected between said second sense node (62) and the flash clear input and the gate thereof connected to said first sense node (60);
first pull up means (64) connected between said first sense node (60) and a power supply (Vcc) for pulling said first sense node to the voltage of said power supply when said first transistor is not conducting;
second pull up means (66) connected between said second sense node (62) and said power supply (Vcc) for pulling said second sense node to the voltage of said power supply when said first transistor is not conducting;
an access transistor (68) having the source-to-drain path thereof connected between said first sense node and said column address decode means (20) and the gate thereof connected to said row address decode means (16,18); and
said first sense node forced to a voltage level corresponding to a first logic state when the flash clear input is raised to a first voltage level (Vcc).

12. A memory according to any of claims 1 to 11 wherein when the flash clear signal is generated, memory cells in the remaining unselected pairs of columns do not change value.

13. A memory according to any of claims 1 to 12 wherein all pairs containing the same data bit of different column addresses are selected.

14. A memory according to any of claims 1 to 12 wherein pairs containing the same data bit of only selected column addresses are selected.

15. A method for selectively clearing memory cells in a multiple input/output memory, comprising:
disposing memory cells (42) in an array in rows and columns;
connecting memory cells in pairs (34) of adjacent columns (COL0,COL1;COL2,COL3) to a first common conductive run (38) disposed adjacent the columns in each pair;
connecting a flash clear signal to first common conductive runs of pairs of adjacent columns to be flash cleared,
characterised in that said columns of memory cells are configured such that a given column address is associated with a group of said columns of memory cells, each of said columns of memory cells in each group (COL0 ... COLN) associated with a separate data bit (DB0 ... DBN) in a bit sequence and wherein each pair of adjacent columns includes columns associated with the same data bit of separate column addresses, wherein said flash clear signal is connected to the memory cells in selected pairs such that memory cells in columns of the selected pairs containing the same data bit of different bit sequences are forced to a first logic state.

## Patentansprüche

1. Speicher mit selektiv löschbaren bzw. freigebbaren Speicherzellen,
mit einer Anordnung (10) von Speicherzellen (42), die in Zeilen und Spalten (COL) angeordnet sind, die Speicherzellen (42) enthalten, die betreibbar sind, um einen ersten oder einen zweiten logischen Zustand darin zu speichern, und die einen Schnellöscheingang (28) haben, um deren gespeicherten logischen Zustand in Abhängigkeit zu dem Empfang eines Schnellöschsignals in den ersten logischen Zustand zu bringen bzw. zu forcieren, wobei die Schnellöscheingänge für die Speicherzellen an einer der gegebenen Spalten gemeinsam miteinander angeschlossen sind;
mit Zeilenadressendekodermitteln (16, 18), um eine Zeilenadresse zu empfangen und zu dekodieren, und auf eine zugehörige der Speicherzellenzeilen in der Anordnung zuzugreifen;
mit Eingabe-/Ausgabemitteln (22), um einen Anschluß zu denjenigen der Speicherzellen herzustellen, auf die zugegriffen wird, um Daten für eine Schreiboperation einzugeben und um Daten für eine Leseoperation auszugeben, wobei die Speicherzellen in Paaren (34) benachbarter Spalten (COL0; COL1; COL2, COL3) mit ihren gemeinsam angeschlossenen Schnellösch- bzw. -freigabeeingängen an Schnellösch- bzw. -freigabemitteln angeschlosen sind, die eine erste gemeinsame leitende Bahn (38) enthalten, die an die Spalten in jedem Paar angrenzend angeordnet ist, wobei die erste gemeinsame leitfähige Bahn angeordnet ist, um ein Schnellösch- bzw. -freigabesignal zum Anschließen an die gemeinsam angeschlossenen Schnellöscheingänge der zugehörigen der Speicherzellen zu empfangen, um diese in Abhängigkeit zu dem Löschsignal zu löschen,
dadurch **gekennzeichnet**, daß die Speicherzellenspalten so angeordnet bzw. konfiguriert sind, daß eine gegebene Spaltenadresse einer Gruppe der Speicherzellenspalten zugeordnet ist, wobei Spaltenadressendekodermittel betreibbar sind, um die Gruppe der Speicherzellenspalten auszuwählen, die einer empfangenen Spaltenadresse zugeordnet ist, wobei jede der Speicherzellenspalten in jeder Gruppe (COL0 ... COLN) einem gesonderten Datenbit (DB0 ... DBN) in einer Bitsequenz zugeordnet ist, und jedes Paar (34) angrenzender Spalten Spalten enthält, die demselben Datenbit (DB0) von gesonderten Spaltenadressen (COL0, COL1; COL2, COL3) zugeordnet sind, wobei das Schnellöschmittel (28, 30, 38) betreibbar ist, um das Schnellöschsignal an die gemeinsam angeschlossenen Schnellöscheingänge der Speicherzellen in ausgewählten Paaren so anzuschließen, daß die Speicherzellen in den Spalten der ausgewählten Paare, die dasselbe Datenbit (DB0) verschiedener Bitsequenzen enthalten, in den ersten logischen Zustand gebracht werden.

2. Speicher nach Anspruch 1, in dem die Speicherzellen statische Speicherzellen (42) aufweisen.

3. Speicher nach einem der Ansprüche 1 oder 2, bei dem das Schnellöschmittel weiterin folgendes aufweist:
eine zweite leitfähige Bahn (28), die angrenzend an die Anordnung (10) und in der Nähe von jeder der Speicherzellenspalten angeordnet ist, wobei die zweite leitfähige Bahn an diejenige der ersten leitfähigen Bahnen (38) angeschlossen ist, die den ausgewählten Paaren der Zellenspalten zugeordnet sind; und
eine Treibereinrichtung (30), um das Schnellöschsignal zu empfangen und um die zweite leitfähige Bahn (28) und die daran angeschlossenen ersten leitfähigen Bahnen (38) mit dem Löschsignal anzutreiben bzw. anzusteuern, um das Schnelllöschsignal sämtlichen der Speicherzellen zuzuführen, deren Schnellöscheingänge über die zugehörigen bzw. zugeordneten ersten leitenden Bahnen an die zweite leitfähige Bahn angeschlossen sind.

4. Speicher nach Anspruch 3, in der die Treibereinrichtung mehrere Treiberschaltungen (49, 51) aufweist, die entlang der zweiten leitenden Bahn verteilt sind, in der die Treiberschaltungen gleichzeitig mit einem Schnellöschsignal die zweite leitfähige Bahn antreiben bzw. ansteuern.

5. Speicheranordnung nach Anspruch 4, in der die Treiberschaltungen in einer Dimension der Anordnung in gleichmäßigen Abständen entlang der zweiten leitfähigen Bahn beabstandet angeordnet sind und zu sämtlichen Spalten der Anordnung, einschließlich jener, die nicht an die gemeinsamen leitenden Bahnen angeschlossen sind, ausgerichtet sind.

6. Speicher nach einem der Ansprüche 3, 4 oder 5, der Mittel zum wahlweisen Anschließen derjenigen der ersten leitfähigen Bahnen (38) an die zweite leitende Bahn (28) aufweist, die den ausgewählten Paaren zugeordnet sind.

7. Speicher nach Anspruch 6, in den die zweite leitfähige Bahn benachbart zu der Anordnung und senkrecht zu den ersten leitfähigen Bahnen angeordnet ist und die Verbindungsmittel eine leitfähige Verbindung zwischen denjenigen der ersten leitfähigen Bahnen aufweisen, die den ausgewählten Paaren der Spalten und der zweiten leitfähigen Bahn zugeordnet sind.

8. Speicher nach einem der vorhergehenden Ansprüche, in dem
das Schnellöschsignal (CLKVss) einen ersten Zustand mit einem ersten Spannungspegel (Vcc) und einen zweiten Zustand mit einem zweiten Spannungspegel (Vss) hat, und jede der Speicherzellen (42) betreibbar ist, um den darin gespeicherten logischen Zustand in den ersten logischen Zustand zu bringen, wenn der erste Spannungspegel an deren Schnellöscheingang angelegt wird, und wobei der logische Zustand der Speicherzellen nicht geändert wird, wenn der zweite Spannungspegel an deren Schnellöscheingang angelegt wird; und
das Schnellöschmittel (49, 51) betreibbar ist, um den ersten Spannungspegel (Vcc) an die Schnellöscheingänge der Speicherzellen der ausgewählten Paare (34) der Spalten und den zweiten Spannungspegel (Vss) an die Schnellöscheingänge der Speicherzellen der nicht ausgewählten Paare der Spalten anzulegen, wenn das besagte Schnellöschsignal anliegt.

9. Speicher nach Anspruch 8, in dem die Mittel zum Anlegen des ersten Spannungspegels an die zweite leitfähige Bahn einen Treiber (49) aufweist, dessen Eingang mit dem Schnellöscheingang verbunden ist, und dessen Ausgang beitreibbar ist, um die zweite leitfähige Bahn anzusteuern.

10. Speicher nach einem der vorhergehenden Ansprüche, in dem die ersten und zweiten leitfähigen Bahnen eine verteilte Kapazität haben, die damit verbunden ist.

11. Speicher nach einem der vorhergehenden Ansprüche, bei dem jede der Speicherzellen aufweist:
einen ersten Abtast- bzw. Abfrageknotenpunkt (60);
einen zweiten Abtast- bzw. Abfrageknotenpunkt (62);
einen ersten Transistor (56), der einen Durchgang von der Source zu dem Drain aufweist, der zwischen einem ersten Abtast- bzw. Abfrageknotenpunkt (60) und einem Knotenpunkt, der einen zweiten Spannungspegel (Vss) zur Verfügung stellt, angeschlossen ist und dessen Gate mit dem zweiten Abtast- bzw. Abfrageknotenpunkt (62) verbunden ist;
einen zweiten Transistor (58), der einen Durchgang von dessen Source zu dessen Drain zwischen dem zweiten Abtast- bzw. Abfrageknotenpunkt (62) und dem Schnellöscheingang angeschlossen ist, und dessen Gate an den ersten Abtast- bzw. Abfrageknotenpunkt (60) angeschlossen ist;
ein erste Hochsetz- bzw. Pull-up-Einrichtung (64), die zwischen dem ersten Abtast- bzw. Abfrageknotenpunkt (60) und einer Stromversorgung (Vcc) angeschlossen ist, um den ersten Abtast- bzw. Abfrageknotenpunkt auf die Spannung der Stromversorgung hochzusetzen, wenn der erste Transistor nichtleitend ist;
eine zweite Hochsetz- bzw. Pull-up-Einrichtung (66), die zwischen dem zweiten Abtast- bzw. Abfrageknotenpunkt (62) und der Stromversorgung (Vcc) angeschlossen ist, um den zweiten Abtast- bzw. Abfrageknotenpunkt auf die Spannung der Stromversorgung hochzusetzen, wenn der erste Transistor nichtleitend ist;
ein Zugrifftransistor (68), dessen Durchgang von der Source zu dem Drain zwischen dem ersten Abtast- bzw. Abfrageknotenpunkt und dem Spaltenadressdekodierungsmittel (20) angeschlossen ist und dessen Gate mit den Zeilenadressendekodierungsmitteln (16, 18) verbunden ist; und
der erste Abtast- bzw. Abfrageknotenpunkt, der auf einen Spannungspegel gebracht bzw. gezwungen wird, der einem ersten logischen Zustand entspricht, wenn der Schnellöscheingang auf einen ersten Spannungspegel (Vcc) angehoben wird.

12. Speicher nach einem der vorhergehenden Ansprüche 1 bis 11, in dem Speicherzellen in den verbleibenden, nichtgewählten Paaren von Spalten den Wert nicht ändern, wenn das Schnellöschsignal erzeugt wird.

13. Speicher nach einem der Ansprüche 1 bis 12, in dem sämtliche Paare, die dasselbe Datenbit verschiedener Spaltenadressen enthalten, ausgewählt werden.

14. Speicher nach irgendeinem der Ansprüche 1 bis 12, in dem Paare, die dasselbe Datenbit nur von ausgewählten Spaltenadressen enthalten, gewählt werden.

15. Verfahren zum selektiven Löschen von Speicherzellen in einem Mehrfach-Eingabe-Ausgabe-Speicher, der folgendes aufweist:
Speicherzellen (42) werden in einer Anordnung in Zeilen und Spalten angeordnet;
Speicherzellen werden in Paaren (34) von benachbarten Spalten (COL0, COL1; COL2, COL3) an eine erste gemeinsame leitfähige Bahn (38) angeschlossen, die an die Spalten in jedem Paar angrenzend angeordnet ist;
ein Schnellöschsignal wird an die ersten gemeinsamen leitfähigen Bahnen von Paaren benachbarter bzw. angrenzender Spalten angeschlossen, um schnell gelöscht zu werden,
dadurch **gekennzeichnet**, daß die Speicherzellenspalten so angeordnet bzw. konfiguriert sind, daß einer gegebenen Spaltenadresse eine Gruppe der Speicherzellenspalten zueordnet wird, wobei jeder der Speicherzellenspalten in jeder Gruppe (COL0 ... COLN) ein gesondertes Datenbit (DB0 ... DBN) in einer Bitsequenz zugeordnet wird, und in dem jedes Paar benachbarter Spalten Spalten enthält, die demselben Datenbit gesonderter Spaltenadressen zugeordnet werden, in dem das Schnellöschsignal mit den Speicherzellen in ausgewählten Paaren so verbunden bzw. angeschlossen wird, daß Speicherzellen in den Spalten der ausgewählten Paare, die dasselbe Datenbit verschiedener Bitsequenzen enthalten, in einen ersten logischen Zustand gebracht bzw. gezwungen werden.

## Revendications

1. Mémoire avec des cellules mémoire effaçables de façon sélective comprenant :
- une matrice (10) de cellules mémoire (42) disposées en rangées et colonnes (COL) comprenant des cellules mémoire (42) utilisables pour mémoriser un premier ou un second état logique à l'intérieur, et pourvue d'une entrée d'effacement rapide (28) destinée à forcer l'état logique mémorisé à l'intérieur vers ledit premier état logique en réponse à la réception d'un signal d'effacement rapide, les entrées d'effacement rapide pour lesdites cellules mémoire dans l'une des colonnes donnée parmi lesdites colonnes étant toutes reliées en commun,
- des moyens de décodage d'adresse de rangée (16, 18) destinés à recevoir et à décoder une adresse de rangée et à accéder à l'une des rangées associée parmi lesdites rangées de cellules mémoire dans ladite matrice,
- des moyens d'entrée/sortie (22) destinés à assurer la liaison avec celles desdites cellules mémoire auxquelles on accède pour entrer des données dans celles-ci dans le cas d'une opération d'écriture, et pour extraire des données de celles-ci dans le cas d'une opération de lecture, dans laquelle les cellules mémoire de paires (34) de colonnes adjacentes (COL0 ; COL1 ; COL2, COL3) ont leurs entrées d'effacement rapide, reliées en commun, qui sont reliées à un moyen d'effacement rapide comprenant un premier circuit conducteur commun (38) disposé de façon adjacente aux colonnes dans chaque paire, ledit premier circuit conducteur commun étant disposé de façon à recevoir un signal d'effacement rapide, pour relier les entrées d'effacement rapide, reliées en commun, des cellules mémoire associées, parmi lesdites cellules mémoire, afin d'effacer celles-ci en réponse audit signal d'effacement,
caractérisée en ce que lesdites colonnes de cellules mémoire sont configurées de telle façon qu'une adresse de colonne donnée est associée à un groupe desdites colonnes de cellules mémoire, en ce que la mémoire comprend un moyen de décodage d'adresse de colonne utilisable pour sélectionner le groupe desdites colonnes de cellules mémoire associé avec l'adresse de colonne reçue, chacune desdites colonnes de cellules mémoire dans chaque groupe (COL0 ... COLN) étant associée avec un bit de donnée distinct (DB0 ... DBN) dans une série de bits, chaque paire (34) de colonnes adjacentes comprenant des colonnes associées avec le même bit de donnée (DB0) d'adresses de colonnes distinctes (COL0, COL1 ; COL2, COL3), dans lequel ledit moyen d'effacement rapide (28, 30, 38) est utilisable pour relier le signal d'effacement rapide aux entrées d'effacement rapide reliées en commun des cellules mémoire dans des paires sélectionnées, de telle façon que les cellules mémoire des colonnes des paires sélectionnées contenant le même bit de donnée (DB0) des différentes séries de bits soient forcées dans ledit premier état logique.

2. Mémoire selon la revendication 1, caractérisée en ce que les cellules mémoire comprennent des cellules mémoire statiques (42).

3. Mémoire selon les revendications 1 ou 2, caractérisée en ce que ledit moyen d'effacement rapide comprend de plus :
- un second circuit conducteur (28) disposé de façon adjacente à ladite matrice (10) et à proximité de chacune desdites colonnes de cellules mémoire, ledit second circuit conducteur étant relié à ceux desdits premiers circuits conducteurs (38) associés avec les paires desdites cellules mémoire sélectionnées, et
- un moyen de commande (30) pour recevoir ledit signal d'effacement rapide et pour commander ledit second circuit conducteur (28), et ceux desdits premiers circuits conducteurs (38) qui lui sont reliés, avec ledit signal d'effacement afin de délivrer ledit signal d'effacement rapide à l'ensemble desdites cellules mémoire dont les entrées d'effacement rapide sont reliées, à travers ceux des premiers circuits conducteurs associés, audit second circuit conducteur.

4. Mémoire selon la revendication 3, caractérisée en ce que le moyen de commande comprend une pluralité de circuits de commande (49, 51) répartis le long du second circuit conducteur, dans laquelle les circuits de commande commandent simultanément un signal d'effacement rapide sur le second circuit conducteur.

5. Matrice de mémoire selon la revendication 4, caractérisée en ce que les circuits de commande sont espacés à intervalles réguliers le long du second circuit conducteur dans un sens de la matrice, et sont alignés avec l'ensemble des colonnes de la matrice, incluant celles qui ne sont pas reliées aux circuits conducteurs communs.

6. Mémoire selon la revendication 3, 4 ou 5, caractérisée en ce qu'elle comprend un moyen d'interconnexion pour relier de façon sélective ceux desdits premiers circuits conducteurs (38) associés avec lesdites paires sélectionnées, audit second circuit conducteur (28).

7. Mémoire selon la revendication 6, caractérisée en ce que ledit second circuit conducteur est disposé de façon adjacente à ladite matrice et est perpendiculaire auxdits premiers circuits conducteurs, et en ce que le moyen d'interconnexion comprend une liaison conductrice entre ceux desdits premiers circuits conducteurs associés avec les paires sélectionnées desdites colonnes et ledit second circuit conducteur.

8. Mémoire selon l'une quelconque des revendications 1 à 7, caractérisée en ce que :
- ledit signal d'effacement rapide (CLKVss) présente un premier état à un premier niveau de tension (Vcc) et un second état à un second niveau de tension (Vss), et chacune desdites cellules mémoire (42) fonctionne de telle façon que l'état logique mémorisé à l'intérieur peut être forcé vers ledit premier état logique lorsque ledit premier niveau de tension est appliqué sur son entrée d'effacement rapide, et l'état logique desdites cellules mémoire n'est pas affecté lorsque le second niveau de tension est appliqué sur leurs entrées d'effacement rapide, et
- ledit moyen d'effacement rapide (49, 51) fonctionne de façon à délivrer ledit premier niveau de tension (Vcc) sur les entrées d'effacement rapide desdites cellules mémoire dans les paires sélectionnées (34) desdites colonnes, et ledit second niveau de tension (Vss) sur les entrées d'effacement rapide desdites cellules mémoire sur les paires non sélectionnées desdites colonnes lorsque ledit signal d'effacement rapide est présent.

9. Mémoire selon la revendication 8, caractérisée en ce que ledit moyen d'application dudit premier niveau de tension sur ledit second circuit conducteur comprend une unité de commande (49) ayant son entrée reliée à ladite entrée d'effacement rapide et sa sortie utilisable pour commander ledit second circuit conducteur.

10. Mémoire selon l'une quelconque des revendications 1 à 9, caractérisée en ce que lesdits premier et second circuits conducteurs présentent une capacité répartie associée avec ceux-ci.

11. Mémoire selon l'une quelconque des revendications 1 à 10, caractérisée en ce que chacune desdites cellules mémoire comprend :
- un premier noeud de détection (60),
- un second noeud de détection (62),
- un premier transistor (56) ayant un chemin source-drain relié entre ledit premier noeud de détection (60) et un noeud délivrant un second niveau de tension (Vss) et dont la grille de commande est reliée audit second noeud de détection (62),
- un second transistor (58) ayant un chemin source-drain relié entre ledit second noeud de détection (62) et l'entrée d'effacement rapide et dont la grille de commande est reliée audit premier noeud de détection (60),
- un premier moyen de rappel (64), relié entre ledit premier noeud de détection (60) et une source d'alimentation (Vcc), destiné à monter ledit premier noeud de détection à la tension de ladite source d'alimentation lorsque ledit premier transistor n'est pas conducteur,
- un second moyen de rappel (66), relié entre ledit second noeud de détection (62) et ladite source d'alimentation (Vcc), destiné à monter ledit second noeud de détection à la tension de ladite source d'alimentation lorsque ledit second transistor n'est pas conducteur,
- un transistor d'accès (68) ayant un chemin source-drain relié entre ledit premier noeud de détection et ledit moyen de décodage d'adresse de colonne (20) et dont la grille de commande est reliée audit moyen de décodage d'adresse de rangée (16, 18), et
- ledit premier noeud de détection est forcé à un niveau de tension correspondant à un premier état logique lorsque l'entrée d'effacement rapide est portée au premier niveau de tension (Vcc).

12. Mémoire selon l'une quelconque des revendications 1 à 11, caractérisée en ce que, lorsque le signal d'effacement rapide est produit, les cellules mémoire dans les paires de colonnes non sélectionnées restantes ne changent pas d'état.

13. Mémoire selon l'une quelconque des revendications 1 à 12, caractérisée en ce que l'ensemble des paires contenant le même bit de donnée d'adresses de colonnes différentes est sélectionné.

14. Mémoire selon l'une quelconque des revendications 1 à 12, caractérisée en ce que les paires contenant le même bit de donnée des seules adresses de colonnes sélectionnées sont sélectionnées.

15. Procédé pour l'effacement sélectif de cellules mémoire dans une mémoire à entrée/sortie multiple, comprenant :
- la disposition de cellules mémoire (42) dans une matrice en rangées et colonnes,
- la connexion des cellules mémoire par paires (34) de colonnes adjacentes (COL0, COL1 ; COL2, COL3) à un premier circuit conducteur commun (38) disposé de façon adjacente aux colonnes dans chaque paire,
- la connexion d'un signal d'effacement rapide sur les premiers circuits conducteurs communs des paires de colonnes adjacentes à effacer de façon rapide,
caractérisé en ce que lesdites colonnes de cellules mémoire sont configurées de telle sorte qu'une adresse de colonne donnée est associée avec un groupe desdites colonnes de cellules mémoire, chacune desdites colonnes de cellules mémoire dans chaque groupe (COL0 ... COLN) étant associée avec un bit de donnée distinct (DB0 ... DBN) dans une série de bits, et dans lequel chaque paire de colonnes adjacentes comprend des colonnes associées avec le même bit de donnée d'adresses de colonnes distinctes, dans lequel ledit signal d'effacement rapide est relié aux cellules mémoire dans des paires sélectionnées de telle façon que les cellules mémoire dans les colonnes des paires sélectionnées contenant le même bit de donné de différentes séries de bits sont forcées vers un premier état logique.
